Europäisches Patentamt

European Patent Office

Office européen des brevets

(11) Publication number: **0 292 327**
A2

# EUROPEAN PATENT APPLICATION

(21) Application number: **88304640.1**

(22) Date of filing: **23.05.88**

(51) Int. Cl.⁴: **H 01 L 27/02**
**H 01 L 27/06**

(30) Priority: **22.05.87 JP 125567/87**

(43) Date of publication of application:
**23.11.88 Bulletin 88/47**

(84) Designated Contracting States: **DE FR GB NL**

(71) Applicant: **SONY CORPORATION**
**7-35 Kitashinagawa 6-Chome Shinagawa-ku**
**Tokyo 141 (JP)**

(72) Inventor: **Yamada, Takaaki c/o Patent Division**
**Sony Corporation 6-7-35 Kitashinagawa**
**Shinagawa-ku Tokyo 141 (JP)**

**Watanabe, Kazuo c/o Patent Divison**
**Sony Corporation 6-7-35 Kitashinagawa**
**Shinagawa-ku Tokyo 141 (JP)**

(74) Representative: **Pilch, Adam John Michael et al**
**c/o D. Young & Co. 10 Staple Inn**
**London WC1V 7RD (GB)**

(54) **Electrostatic breakdown protection circuits.**

(57) An electrostatic breakdown protection circuit is connected to an input terminal (2) of an integrated circuit device for preventing electrostatic breakdown of its internal circuit (3). An MOS transistor (1), connected in parallel with a parasitic bipolar transistor (5), is connected to the input terminal (2) so as to improve the protection capability of the circuit.

**FIG.1**

**Description**

## ELECTROSTATIC BREAKDOWN PROTECTION CIRCUITS

This invention relates to electrostatic breakdown protection circuits connected to input terminals of, for example, integrated circuit devices, and arranged to protect the integrated circuit devices against excess input voltage.

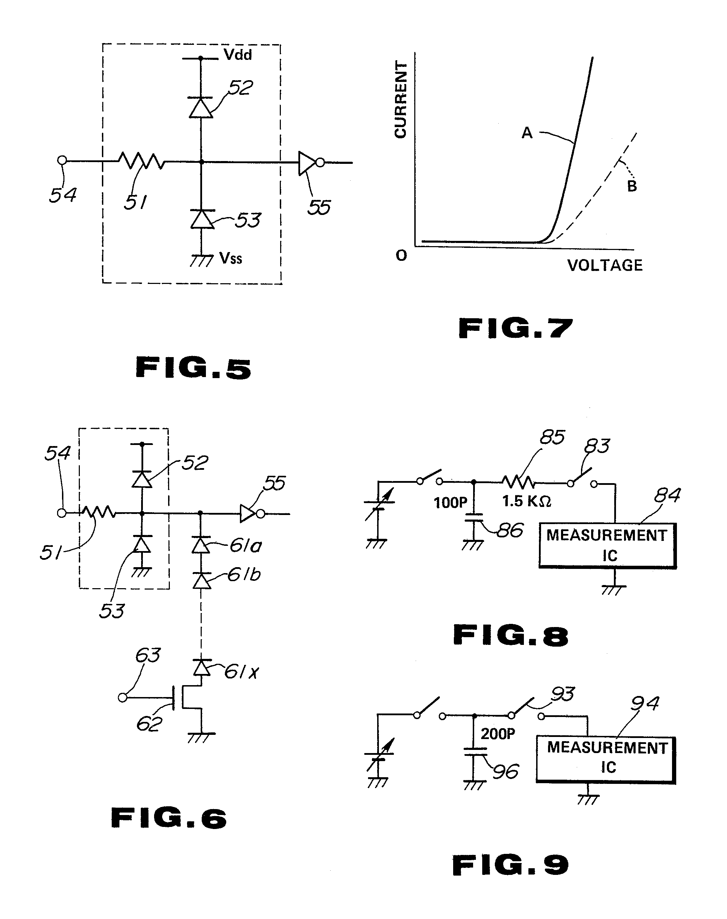

In an integrated circuit (IC) or the like, an electrostatic protection circuit is often provided at the input terminal in order to prevent breakdown caused by build-up of electrostatic charge. One prior proposal for an electrostatic protection circuit is shown in the circuit diagram of Figure 5 of the accompanying drawings. The electrostatic protection circuit has a resistor 51, one end of which is connected to an input terminal 54 and the other end of which is connected to a node at the positive terminal of a diode 52 and the negative terminal of a diode 53. The negative terminal of the diode 52 is at source voltage $V_{dd}$ while the positive terminal of the diode 53 is at ground or earth potential $V_{ss}$. The node is connected to an internal circuit 55 arranged to process the signals in a required manner.

When a voltage pulse is applied to the input terminal 54 of the electrostatic protection circuit, a current limiting operation is achieved by the resistor 51, and thereby effective protection is provided. However, when a current pulse is applied, the current limiting effect is not achieved unless the resistance of the resistor 51 is enlarged so that optimum protection is not realised. In this case, when a higher resistance of, for example 3 kilohms, is to be formed by a polysilicon layer or by a diffusion resistor, the resistance area is correspondingly increased thereby adversely affecting the chip layout and the chip area, which is counter to the tendency towards increased density. In a high speed memory, the input resistance and the input capacitance are increased by the area of the increased resistance, thus causing a delay in operations, typically of the order of several nanoseconds.

In a large capacity memory, redundant circuits are used to increase the yield. In order to check subsequently whether the redundant circuits are used in connection with the chips employed, a so-called address roll call circuit may be formed in the chip. The roll call circuit may be constructed as shown, for example, in Figure 6 of the accompanying drawings, in which the circuit is composed of series-connected diodes 61a, 61b, ....., 61x and an NMOS (n-channel metal-oxide semiconductor) transistor 62 positioned at the end of the diode array. Signals are applied to the gate 63 of the NMOS transistor 62 depending on whether the redundant circuit has or has not been employed such that a high voltage in excess of the usual voltage is applied to the input terminal 54 in order to detect whether the above use has been made. However, when such a roll call circuit is combined with an electrostatic protection circuit as shown in Figure 5, the current will flow in the diode 52 upon impressing a high voltage for reading so that a reading by the roll call circuit becomes not feasible. Thus, in the known type of chip, it has not been possible to use the previously-proposed electrostatic protection circuit.

When using an MOS transistor in an electrostatic protection circuit, the following problems arise between the well region and the parasitic resistance. When the channel width is reduced in size with a view to increasing the density to meet demands for miniaturisation and faster speed, the parasitic resistance correponding to the resistance of the well region is increased such that the breakdown characteristic is shifted from the ideal characteristic shown in Figure 7 of the accompanying drawings by the solid line A, to the characteristic shown in the drawing by the phantom line B. At this time, the breakdown voltage for a particular current is increased. However, the gate breakdown voltage of the MOS transistor constituting the internal circuit is correlatively lowered compared to the increased breakdown voltage such that the protective capacity is lost by dielectric destruction of the gate.

According to one aspect of the invention there is provided an electrostatic breakdown protection circuit provided between a connection terminal and an internal circuit, the protection circuit comprising:

a semiconductive region of a first conduction type;

an MOS transistor having a gate, a source and a drain, formed by a semiconductive region of a second conduction type and formed in said semiconductive region of the first conduction type, means for connecting said drain to said connection terminal and means for connecting said source and said gate to a predetermined electrical voltage;

a parasitic bipolar transistor having said semiconductive region of the first conduction type as its base region and said semiconductive region of said second conduction type as its collector and emitter regions, said bipolar transistor being connected in parallel with said MOS transistor; and

a parasitic resistor formed by said semiconductive region of said first conduction type;

whereby said parasitic bipolar transistor is caused to be operated by the potential difference across said parasitic resistor on occurrence of an excess input voltage having an opposite polarity to said predetermined voltage.

According to another aspect of the invention there is provided an electrostatic breakdown protection circuit provided between a connection terminal and an internal circuit, the protection circuit comprising:

a well region of a first conduction type formed in a semiconductor substrate of a second conduction type;

an MOS transistor including a gate, a source region and a drain region consisting of a region of the second conduction type formed in said well region of the first conduction type, means for connecting said drain region to said connection terminal, said gate and the source each having a U-shape and being formed around the drain, and means for connecting said gate and the source to a predetermined voltage;

a parasitic bipolar transistor having said well region of the first conduction type as its base region and said region of the second conduction type as its collector region, said bipolar transistor including an emitter region of the second conduction type surrounding said well region of the first conduction type and being connected in parallel with said MOS transistor; and

a parasitic resistor formed by said well area of the first conduction type;

whereby said parasitic bipolar transistor is caused to be operated by the potential difference across said parasitic resistor on occurrence of an excess input voltage having an opposite polarity relative to said predetermined voltage.

According to a further aspect of the invention there is provided an electrostatic protection circuit comprising a field effect transistor having its drain connected to an input terminal and its source and gate supplied with a predetermined voltage, a parasitic lateral bipolar transistor connected in parallel to said field effect transistor, a parasitic resistance formed by an impurity region forming a channel of said field effect transistor, said parasitic lateral bipolar transistor being operated by the potential difference across said parasitic resistance on occurrence of an excess input voltage having an opposite polarity to said predetermined voltage, thereby to realise an improved protective function.

A preferred embodiment of this invention, to be described in greater detail hereinafter, provides an improved electrostatic protection circuit, particularly one which prevents dielectric destruction of the internal circuit. The preferred electrostatic protection circuit may utilise a roll call circuit in a chip.

The invention will now be described by way of example with reference to the accompanying drawings, throughout which like parts are referred to by like references, and in which:

Figure 1 is a circuit diagram showing an electrostatic protection circuit according to an embodiment of the present invention;

Figure 2 shows a layout of the contact and the impurity region in the circuit of Figure 1;

Figure 3 is a sectional view taken along a line III-III in Figure 2;

Figure 4 shows a layout of the interconnecting layer in the electrostatic protection circuit of Figures 1 to 3;

Figure 5 is a circuit diagram illustrating a previously-proposed protection circuit;

Figure 6 is a circuit diagram illustrating a roll call circuit;

Figure 7 is a diagram showing the breakdown characteristics of MOS transistors in general;

Figure 8 is a circuit diagram of a measurement circuit for the MIL standard; and

Figure 9 is a circuit diagram of a measurement circuit for the Japanese standard.

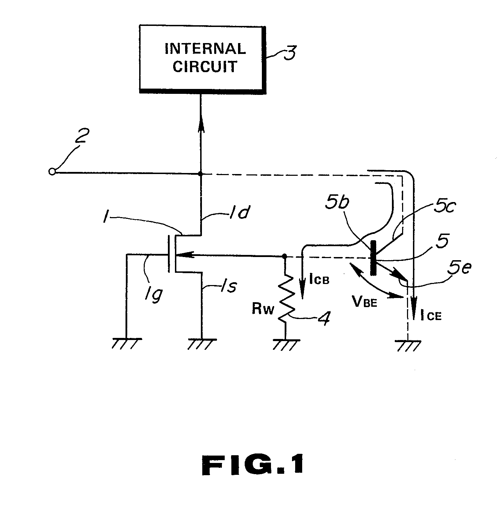

The basic circuit construction of an electrostatic protection circuit embodying the present invention is shown in Figure 1. The electrostatic protection circuit is connected between an input terminal 2 and an internal circuit 3 for performing the required signal processing, and includes an NMOS (n-channel metal-oxide semiconductor) transistor 1 connected to the input terminal 2, a parasitic resistor 4 and a parasitic bipolar transistor (lateral bipolar transistor) 5.

The NMOS transistor 1 has its drain 1d connected to the input terminal 2 and its gate 1g and source 1s connected to earth potential $V_{ss}$, its channel being formed by, for example, a P-well region or impurity region, and its P-well region constituting the aforementioned parasitic resistor 4. On occurrence of an excess negative-polarity input voltage, the drain 1d and the channel of the NMOS transistor 1 act together as a diode. On occurrence of an excess input voltage having a positive polarity relative to the earth voltage $V_{ss}$, the parasitic bipolar transistor 5 is turned on (as will be later described) to provide electrostatic protection.

The parasitic resistor 4 is formed by the above-mentioned P-well region (which is the impurity region) forming the channel of the NMOS transistor 1, this P-well region being connected to earth potential $V_{ss}$. According to the present arrangement, the parasitic resistor 4 ($R_w$) can generate a potential difference $R_w.I_{CB}$ in response to the extremely small current $I_{CB}$, thereby to turn on the parasitic bipolar transistor 5. In other words, the parasitic resistor 4 has a resistance such as to produce a potential difference larger than the turn-on voltage of the parasitic bipolar transistor. The resistance determines the operation start voltage of the parasitic bipolar transistor 5.

The parasitic bipolar transistor 5 has its collector 5c connected to the input terminal 2 and its base 5b connected to one end of the parasitic resistor 4 and to the channel of the NMOS transistor 1. The emitter of the parasitic bipolar transistor 5 is connected to the earth voltage $V_{ss}$. However, this is only as shown in the equivalent circuit and, in practice, the collector 5c is the drain 1d of the NMOS transistor 1, whereas the base 5b is the channel (or P-well) of the NMOS transistor 1 and the emitter 5e is the source 1s of the NMOS transistor 1.

The electrostatic protection circuit operates in the following manner. The circuit is protected against an excess negative polarity input voltage by the PN-junction diode between the channel and the drain 1d of the NMOS transistor 1.

The operation providing protection against an excess positive-polarity input voltage is as follows. When the excess input voltage is applied to the input terminal 2, a leak current $I_{CB}$ flows through the base 5b and the collector 5c of the parasitic bipolar transistor 5. This leak current $I_{CB}$ is also the extremely small current in the drain 1d of the NMOS transistor 1. This leak current $I_{CB}$ produces a potential difference or voltage drop in the P-well. The magnitude of the potential difference is $R_w.I_{CB}$, where $R_w$ is the resistance of the parasitic resistor 4. This potential difference constitutes the base to emitter voltage $V_{BE}$, and when it is larger than the turn-on voltage (in the order of 0.7V) of the parasitic bipolar transistor 5, the parasitic bipolar transistor 5 is turned on. The current then flowing through the parasitic bipolar transistor 5 is $h_{FE}.I_{CB}$ which has an extremely large value. This prevents destruction of the insulation caused by the concentration of the electric current, and the operation of the parasitic bipolar transistor results in an effective prevention of electrostatic destruction at a lower voltage than the gate dielectric breakdown voltage.

In this manner, in the electrostatic protection circuit of the present embodiment, it is possible to cause the current resulting from the excess input voltage to flow towards the source (emitter) by the operation of the parasitic bipolar transistor 5; the value of the voltage restriction is determined by the collector-base breakdown voltage $V_{CBR}$ of the parasitic bipolar transistor 4. When this is lower than the gate dielectric breakdown voltage, the internal devices are effectively protected with ideal breakdown characteristics, as shown by the solid line A in Figure 7, even when high voltage or current pulses are applied.

The electrostatic protection circuit of the present embodiment is in practice composed only of an NMOS transistor of single channel type. Thus, upon connection of the roll call circuit shown in Figure 6, the current flows through the diode of the electrostatic protection circuit during the readout operation such that the readout operation remains feasible. It is therefore possible to cause positive operation of the roll call circuit using the electrostatic protection circuit of the present embodiment with a large capacity memory device employing redundant circuits.

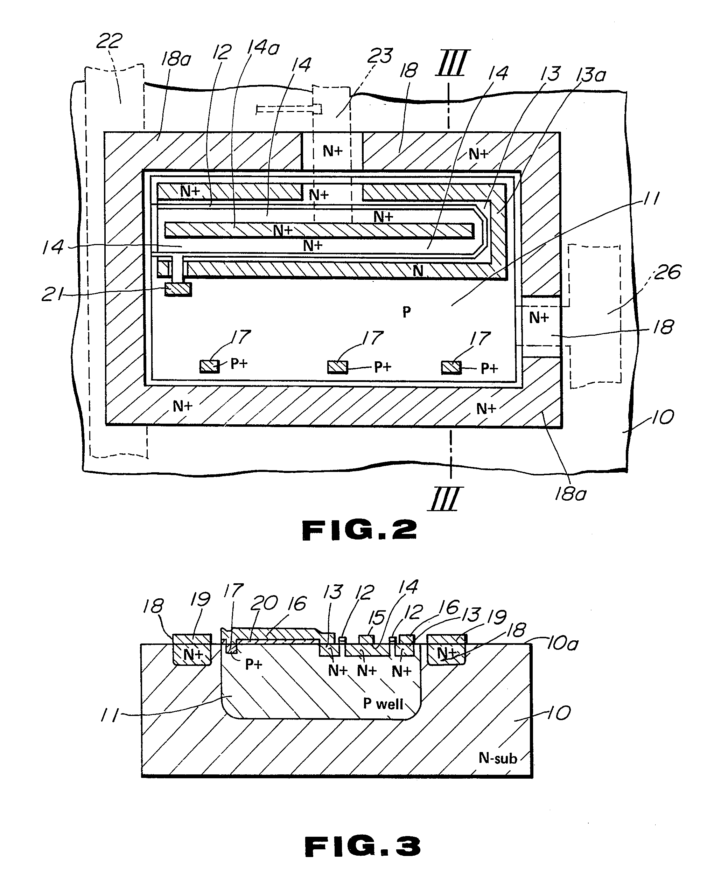

An example of the layout of the electrostatic protection circuit of the present embodiment will now be explained by referring to Figures 2 to 4.

The layout shown in Figure 2 is the layout of the contact and the impurity region of the electrostatic protection circuit of the present embodiment, and comprises an NMOS transistor 1, a parasitic resistor 4 and a parasitic bipolar transistor 5. From the layout, it will be seen that only the NMOS transistor is provided. The shaded area in Figure 3 represents the contact region with an aluminium interconnecting layer deposited on the impurity region.

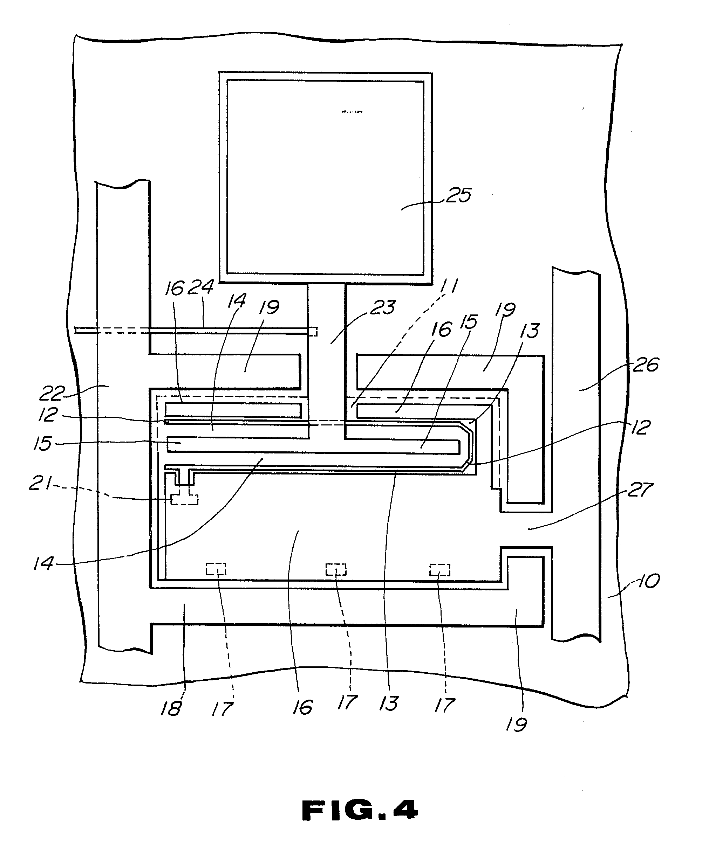

As shown in Figure 2, a substantially rectangular P-well region 11 is formed in the N-type substrate (N-sub) 10, and an N+ type guard ring region 18 is formed surrounding the substantially rectangular P-well region 11 with a small space between it and the P-well region. It will be noted that the guard ring region 18 has an area 18a shown by shaded lines in the drawing, which is the connecting region with an aluminium interconnecting layer 19 which is connected to an aluminium interconnecting layer 22 supplying the source voltage $V_{dd}$ as shown in Figure 4.

The upper half in the drawing (Figure 2) of the P-well region 11 is the area where the source, gate and the drain of the NMOS transistor are provided. A thin strip 12 extends from the left end of the well and delineates a substantially U-shaped loop at the right end of the well, and thence extends to the left end of the well to constitute the gate electrode of the NMOS transistor. This gate electrode is formed by, for example, polycrystal silicon and is connected through a substantially T-shaped extension 21 to an aluminium interconnecting layer 16. The inside of the strip 12 of the substantially level U-shaped gate electrode is the self-aligned drain region 14 of the NMOS transistor formed using the strip 12, and is the N+ type impurity region which is also the collector region of the parasitic bipolar transistor. The drain region 14 is connected to the aluminium interconnecting layer 15 through the shaded area 14a of the drain region. On the other hand, the N+ type impurity area outside the strip 12 of the aforementioned substantially level U-shaped gate electrode is the self-aligned source region 13 of the NMOS transistor, formed similarly to the strip 12, and also operates as the emitter region of the parasitic bipolar transistor. This source region 13 is the elongate substantially U-shaped area shown in Figure 2 in plan view, and is connected through the shaded area 13a of the source region with the aluminium interconnecting layer 16.

The lower half of the P-well region 11 in Figure 2 occupies a larger area for the electrostatic protection circuit of the present embodiment. The object is to obtain a resistance value of the parasitic resistor using the P-well region 11, and the earthed side of the parasitic resistor is connected to the aluminium interconnecting layer 16 through a P+ impurity region 17 doped with high density impurities, as shown in Figure 3.

Figure 4 shows a layout of the interconnecting layer formed on the impurity region shown in Figures 2 and 3. In Figure 4, the larger rectangular region represents a pad portion 25 which is bonded, for example, to an exterior input pin. This pad portion 25 is connected to an aluminium interconnecting layer 15 as the source contact electrode through a strip 23 and to an internal circuit through a thin wire, such as polycrystal silicon, which is connected to a portion of the strip 23. The substantially U-shaped transverse strip 12 is formed for surrounding the aluminium interconnecting layer 15, and this acts as the gate electrode of the NMOS transistor. On the outside of the strip 12 acting as the gate electrode, there is provided an aluminium interconnecting layer 16 connecting the source region 13. This aluminium interconnecting layer 16 is arranged covering the lower half of the well region 11 in the drawing above an insulating layer 20, and connecting to a P+ type impurity region 17 on the P-well (see Figure 3) and to an extension 21 provided for earthing the gate electrode. This aluminium interconnecting layer 16 is connected to an earth line 26 via a strip 17 through the guard ring 18. An aluminium interconnecting layer 19 is connected to a power source line 22 and the source voltage $V_{dd}$ is supplied to the guard ring 18. The aforementioned interconnecting layers are respectively connected at portions shown by shaded lines in Figure 2.

In the electrostatic protection circuit of the present embodiment having the above layout, the P+ type impurity region 17 arranged for taking out the parasitic resistance is provided away from the strip 12 which functions as the gate electrode of the NMOS transistor. Thus, the potential difference is produced by the current generated at the drain side of the channel area under the substantially U-shaped transverse strip 12 and by the parasitic resistance proportionate to the volume of the well region 11. When the potential difference exceeds the aforementioned on-operating voltage, the parasitic bipolar transistor is turned on to cause the current to flow from the collector to the emitter of the parasitic bipolar transistor. Thus, the current flows from the drain region 14 to the source 13, and through the aluminium interconnecting layer 16 to the earth line 26.

The electrostatic protection circuit of the present embodiment is provided with the guard ring region 18 surrounding the well region 11 so as to improve the latchup withstanding characteristics. Above all, the electrostatic protection circuit of the present embodiment is formed formally only by an NMOS transistor and is of a single polarity. This results in further improved latchup withstanding characteristics.

An example of data concerning the electrostatic protection circuit of the present embodiment will be described.

Using an previously-proposed electrostatic protection circuit, having an NMOS transistor with a channel width of 300 microns, voltage levels of 120V and about 800V were obtained respectively under the Japanese standard and the MIL standard. It is to be noted that the measurement circuit for the MIL standard is a current pulse type circuit as shown in Figure 8, in which a measurement IC 84 is connected to a switch 83 with electric charge being supplied to the measurement IC 84 by the electric discharge of a 100 pF capacitor 86 through a resistor 85 of 1.5 kilohms. The Japanese standard measurement circuit is a voltage pulse type circuit as shown in Figure 9, with the electrical charge from a capacitor 96 of 200 pF directly supplied through a switch 93 to the measurement IC 94.

However, in the electrostatic protection circuit of the present embodiment, by operation of the aforementioned parasitic lateral bipolar transistor, levels of not less than 400V and 4000V are respectively obtained for a channel width W of 300 microns with the Japanese standard and the MIL standard, showing that the voltage withstanding characteristics are markedly improved. This also means that the channel width of not less than 1000 microns can be reduced to not more than 300 microns, thus contributing to a reduction in the occupied area.

It will be noted that, although an electrostatic protection circuit employing only NMOS transistors has been explained with reference to the above embodiment, PMOS (p-channel metal-oxide semiconductor) transistors may also be used for similarly improving the voltage withstanding characteristics.

**Claims**

1. An electrostatic breakdown protection circuit provided between a connection terminal (2) and an internal circuit (3), the protection circuit comprising:

a semiconductive region (11) of a first conduction type;

an MOS transistor (1) having a gate (1g), a source (1s) and a drain (1d), formed by a semiconductive region (13, 14) of a second conduction type and formed in said semiconductive region (11) of the first conduction type, means for connecting said drain (1d) to said connection terminal (2) and means for connecting said source (1s) and said gate (1g) to a predetermined electrical voltage (Vss);

a parasitic bipolar transistor (5) having said semiconductive region (11) of the first conduction type as its base region (5b) and said semiconductive region (13, 14) of said second conduction type as its collector and emitter regions (5c,5e), said bipolar transistor (5) being connected in parallel with said MOS transistor; and

a parasitic resistor (4) formed by said semiconductive region (11) of said first conduction type;

whereby said parasitic bipolar transistor (5) is caused to be operated by the potential difference across said parasitic resistor (4) on occurrence of an excess input voltage having an opposite polarity to said predetermined voltage (Vss).

2. A circuit according to claim 1, wherein the semiconductive region (11) of the first conduction type is of the p-type, said semiconductive region (13, 14) of the second conduction type is of the n-type, said MOS transistor (5) is an n-channel transistor, and said parasitic bipolar transistor (5) is an npn transistor.

3. A circuit according to claim 2, wherein said semiconductive region (11) of the first conduction type is a P-well.

4. A circuit according to claim 1, wherein said semiconductive region (11) of the first conduction type is of the n-type, said semiconductive region (13, 14) of the second conduction type is of the p-type, said MOS transistor (5) is a p-channel transistor, and said parasitic bipolar transistor (5) is a pnp transistor.

5. A circuit according to claim 4, wherein said semiconductive region (11) of the first conduction type is an N-well.

6. A circuit according to any one of the preceding claims, wherein the internal circuit (3) comprises a roll-call circuit (Figure 6).

7. An electrostatic breakdown protection circuit provided between a connection terminal (2) and an internal circuit (3), the protection circuit comprising:

a well region (11) of a first conduction type formed in a semiconductor substrate (10) of a second conduction type;

an MOS transistor including a gate (12), a source region (13) and a drain region (14) consisting of a region (13, 14) of the second conduction type formed in said well region (11) of the first conduction type, means for connecting said drain region (14) to said connection terminal (2), said gate (12) and the source each having a U-shape and being formed around the drain (14), and means for connecting said gate (12) and the source to a predetermined voltage (Vss);

a parasitic bipolar transistor having said well region (11) of the first conduction type as its base region and said region(13, 14) of the second conduction type as its collector region, said bipolar transistor including an emitter region of the second conduction type surrounding said well region (11) of the first conduction type and being connected in parallel with said MOS transistor; and

a parasitic resistor formed by said well area (11) of the first conduction type;

whereby said parasitic bipolar transistor is caused to be operated by the potential difference across said parasitic resistor on occurrence of an excess input voltage having an opposite polarity relative to said predetermined voltage (Vss).

8. A circuit according to claim 7, wherein the well region (11) of the first conduction type is of the p-type, the region (13, 14) of the second conduction type is of the n-type, said MOS transistor is an n- channel transistor, and said parasitic bipolar transistor is an npn transistor.

9. A circuit according to claim 7, wherein said well region (11) of the first conduction type is of the n-type, the region (13, 14) of the second conduction type is of the p-type, said MOS transistor is a p-channel transistor, and said parasitic bipolar transistor is a pnp transistor.

21 06 88

0292327

**FIG.1**

**FIG.2**

**FIG.3**

**FIG.4**

FIG.5

FIG.7

FIG.6

FIG.8

FIG.9